(19) Europäisches Patentamt
European Patent Office
Office européen des brevets

(11) **EP 2 816 137 B1**

(12) **EUROPEAN PATENT SPECIFICATION**

(45) Date of publication and mention
of the grant of the patent:
**21.08.2019 Bulletin 2019/34**

(51) Int Cl.:
***C03B 19/14*** *(2006.01)*     ***C23C 16/04*** *(2006.01)*
***C23C 16/455*** *(2006.01)*     ***C23C 16/511*** *(2006.01)*
***C03B 37/018*** *(2006.01)*

(21) Application number: **14184932.3**

(22) Date of filing: **16.11.2012**

(54) **METHOD FOR CARRYING OUT A PCVD DEPOSITION PROCESS**

Verfahren zum Durchführen eines PCVD-Abscheidungsverfahrens

Procédé pour effectuer un processus de dépôt PCVD

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.11.2011 NL 2007831**

(43) Date of publication of application:
**24.12.2014 Bulletin 2014/52**

(62) Document number(s) of the earlier application(s) in
accordance with Art. 76 EPC:
**12192965.7 / 2 594 659**

(73) Proprietor: **Draka Comteq B.V.**
**2627 AN Delft (NL)**

(72) Inventors:
• **Milicevic, Igor**
**2627 AN DELFT (NL)**
• **van Stralen, Mattheus Jacobus Nicolaas**
**2627 AN DELFT (NL)**
• **Hartsuiker, Johannes Antoon**
**2627 AN DELFT (NL)**

(74) Representative: **Algemeen Octrooi- en**
**Merkenbureau B.V.**
**P.O. Box 645**
**5600 AP Eindhoven (NL)**

(56) References cited:
**EP-A- 0 064 785**     **EP-A1- 2 199 263**
**WO-A1-2004/101458**     **US-A1- 2011 247 369**

## Description

The present invention relates a method for carrying out a PCVD deposition process, said method comprising the steps of: i) providing a glass substrate tube; ii) supplying one or more glass-forming gasses to the substrate tube; iii) inducing a plasma by means of microwave radiation on at least a part of the substrate tube to induce deposition of one or more glass layers onto the interior surface of the glass substrate tube, wherein at least one plasma-reactive gas in pure form is supplied to the substrate tube during step iii) in one or more pulses as a function of the axial position of the plasma along the length of the substrate tube.

Plasma-enhanced chemical vapor deposition (PECVD or PCVD) is a process used to deposit thin films from a gas state (vapor) to a solid state on a substrate. Chemical reactions are involved in the process, which occur after creation of a plasma of the reacting gases.

Generally, in the field of optical fibers, multiple thin films of glass are deposited on the inside surface of a substrate tube. Glass-forming gases (viz. doped or undoped reactive gases) are introduced into the interior of the substrate tube from one end (supply side of the substrate tube). Doped or undoped glass layers are deposited onto the interior surface of the substrate tube. The gases are discharged or removed from the other end of the substrate tube, optionally by the use of a vacuum pump (discharge side of the substrate tube). The vacuum pump has the effect of generating a reduced pressure in the interior of the substrate tube, which reduced pressure generally comprises a pressure value ranging between 5 and 50 mbar.

Generally, microwaves from a microwave generator are directed towards an applicator via a waveguide, which applicator surrounds a glass substrate tube. The applicator couples the high-frequency energy into the plasma. The applicator (and hence the plasma formed by that) is moved reciprocally in the longitudinal direction of the substrate tube, as a result of which a thin glass layer is deposited onto the interior of the substrate tube with every stroke or pass.

Thus the applicator is moved in translation over the length of the substrate tube within the boundaries of the furnace. With this translational movement of the resonator the plasma also moves in the same direction. As the resonator reached the inner wall of the furnace near one end of the substrate tube, the movement of the resonator is reversed so that it moves to the other end of the substrate tube towards the other inner wall of the furnace. The resonator and thus the plasma travels a back and forth movement along the length of the substrate tube. Each back and forth movement is call a "'pass" or "stroke". With each pass a thin layer of glass material is deposited on the inside of the substrate tube.

Normally, a plasma is generated only in a part of the substrate tube, viz. the part that is surrounded by the microwave applicator. The dimensions of the microwave applicator are smaller than the dimensions of the furnace and of the substrate tube. Only at the position of the plasma, the reactive gasses are converted into solid glass and deposited on the inside surface of the substrate tube.

When the number of passes increases the cumulative thickness of these thin films, i.e. of the deposited material, increases thus leading to a decrease in the remaining internal diameter of the substrate tube. In other words, the hollow space inside the substrate tube keeps getting smaller with each pass.

The applicator and the substrate tube are generally surrounded by a furnace so as to maintain the substrate tube at a temperature of 900-1300 °C during the deposition process.

One way of manufacturing an optical preform by means of a PCVD process is known from US patent No. 4,314,833 in the name of the present applicant. According to the process that is known from that document, one or more doped or undoped glass layers are deposited onto the interior of a substrate tube, using a low-pressure plasma in the glass substrate tube. After the glass layers have been deposited onto the interior of the glass substrate tube, the glass substrate tube is subsequently contracted by heating into a solid rod ("collapsing"). In a special embodiment, the solid rod may furthermore be externally provided with an additional amount of glass, for example by means of an external vapor deposition process or by using one or more preformed glass tubes, thus obtaining a composite preform. From the preform thus produced, one end of which is heated, optical fibers are obtained by drawing.

According to International application WO 99/35304 in the name of the present applicant, microwaves from a microwave generator are directed towards an applicator via a waveguide, which applicator surrounds a glass substrate tube. The applicator couples the high-frequency energy into the plasma.

From European patent EP 1 550 640 (also published as US 2005/0172902) in the name of the present applicant there is known an apparatus for carrying out a PCVD deposition process, wherein a choke having a specific length and width is centered around the cylindrical axis in the apparatus and is annular in shape, which choke is positioned within the applicator. The dimensions of the choke have been selected to minimize the losses of high-frequency energy during the entire deposition process, which leads to efficient energy consumption. This document relates to microwave leakage and the reduction thereof.

US 4,741,747 relates to methods for reducing optical and geometrical end taper in the PCVD process. The regions of non-constant deposition geometry at the ends of the preform (taper) are reduced by moving the plasma in the area of at least one reversal point nonlinearly with time and/or by changing the longitudinal extent of the plasma as a function of time.

US 4,857,091 relates to a PCVD method of making optical fibers whose refractive index profiles show specific peripheral and/or radial and/or axial optical modulation structures. Parameters are varied which influence: (a) the uniformity of the material transport to the inner wall of the tube and/or the deposition yields of the glass over the tube circumference and/or (b) the axial position of the local deposition zone with respect to the reactor producing the plasma.

GB2068359 relates to a PCVD process, wherein the plasma column is swept along the substrate tube by varying the power input to the device, to effect direct formation of a glass layer along the swept and heated region of the tube.

From European patent application EP 2199263 (also published as US 2010/0154479) by the present applicant is known a PCVD process which can be used to minimize axial refractive index variations along a substrate tube by controlling the gas composition (primarily dopant composition) in the substrate tube as a function of the resonator (plasma zone) position.

From U.S. Patent 6,901,775 there is known an apparatus for internally coating a substrate tube by means of a PCVD process, from which substrate tube a preform is made, wherein the gas delivery unit includes an insert, which is claimed to prevent a disturbance in the gas flow, which disturbance induces a standing wave of a certain period and amplitude in the gas flow. According to said US patent, said standing wave is in turn responsible for a given deposition within the internal region of the substrate tube, which deposition is characterized by a non-uniform thickness along the axial direction thereof.

From European patent application EP 1,923,360 (also published as US 2009/0022906) of the present applicant a PCVD process is known which provides uniform thickness and refractive index deposition in the axial direction of the substrate tube. In this method the furnace is moved reciprocally, e.g. 30 mm, 60 mm, or 15 mm, along the axial direction of the substrate tube. The movement of the furnace is used to reduce the effect of what is believed to be non-uniform distribution of microwave power along the axial direction of the substrate tube, caused by microwave applicator position-dependent reflections of some of the microwave power, e.g. from the inner wall of the surrounding furnace. Such axial microwave power non-uniformity can cause axial deposition thickness and refractive index non-uniformity, which adversely affects fiber quality parameters such as attenuation, mode field width uniformity, and bandwidth uniformity. The method used in EP 1,923,360 only partially solves the problem of leakage of high-frequency energy.

From US application 2011/0247369 published in the name of the current applicant, a PCVD process is known in which the reaction zone moves back and forth in the longitudinal direction over the hollow glass substrate tube. An additional amount of a gas comprising a fluorine-containing compound is supplied to the interior of the hollow glass substrate tube via the supply side thereof when the reaction zone is located near or at the reversal point in order to reduce the number of hydroxyl groups that is incorporated during the internal deposition process.

In the PCVD process the formation of glass deposition on the inside of the substrate tube only takes place at the position at which a plasma is present. The inventors have observed that the position of the front end of the plasma (i.e. the position upstream the flow of glass forming gasses) may vary with respect to the resonator position. This variation is generally a non-monotonously increasing or decreasing function of the resonator position. The deposited glass will show a similar behavior (called "deposition oscillation"). In one pass the deposited smooth thin film will not have a uniform thickness. On the position of the substrate tube where the (cumulative) duration of plasma presence is higher, a larger or thicker layer of glass is formed. This effect is reinforcing itself, meaning that in a next pass the "thick spots" will generate more heat due to the poor heat conductivity of glass and will lead to even more glass deposition in the next layers. This increases the effect of the deposition oscillation. Deposition oscillation is therefore defined as a variation in the thickness or composition of the deposited glass over the length of the substrate tube.

An aspect of the present disclosure is to provide a glass substrate tube having vapor-deposited glass layers of essentially uniform thickness and an essentially uniform refractive index and alpha value in the axial direction, which substrate tube is subsequently further processed into a solid rod via a contraction process. Finally, said solid rod is converted into an optical fiber via a number of processing steps.

The present invention relates to a method according to claim 1 for carrying out a PCVD deposition process, said method comprising the steps of :i) providing a glass substrate tube; ii) supplying one or more glass-forming gasses to the substrate tube of step i); iii) inducing a plasma by means of microwave radiation on at least a part of the substrate tube of step ii) to induce deposition of one or more glass layers onto the interior surface of the substrate tube; wherein at least one plasma-reactive gas in pure form is supplied to the substrate tube during step iii) in one or more pulses as a function of the axial position of the plasma along the length of the substrate tube, characterized in that one single pulse is supplied of plasma-reactive gas and wherein the timing and placement of said pulse is selected to fall in a longitudinal position corresponding to the deposition oscillation said deposition oscillation being a variation in the thickness of the deposited glass over the length of the substrate tube.

In an embodiment, one single pulse is supplied of plasma-reactive gas. In another embodiment, said single pulse has a duration of between 250 and 1000 milliseconds, preferably between 500 and 750 milliseconds.

In an embodiment the pulse is provide in both the forward movement of the pass (going from supply side to discharge side) and on the backward movement of the pass (going from discharge side to supply side). For example in the last 150-400 or 150-200 millimeters of the substrate tube near the discharge side.

In case one pulse is provided the length and position can be selected to be such that the effect is present on the last part of the forward movement and the first part of the backward movement. The length and position of said pulse is therefore selected to fall in a longitudinal position corresponding to the deposition oscillation.

It should be noted that the gas travels through the substrate tube with a speed of for example 10 meter per second, there is thus a kind of a lag phase between the injection of the gas and the moment that it reaches the plasma. A skilled person in the art will be able to determining that lag phase and adjust the position and timing of the gas to account for this. The same goes for the closing of the valve to stop the injection. There will be a lag phase before the presence of plasma-reactive gas is no longer present at the position of the plasma.

In yet another embodiment, the pressure of the plasma-reactive gas is between 0.5 and 5 bar, preferably between 1 and 2 bar.

In the present description a plasma-reactive gas is a non glass-forming precursor gas capable of being ionized in a plasma.

The plasma-reactive gas is selected from the group consisting of Argon, Helium, Oxygen, Nitrogen and one or more combinations thereof.

Moreover, the method according to the present invention can be carried out in an apparatus for carrying out a PCVD deposition process, wherein one or more glass layers are deposited by means of a microwave induced plasma onto the interior surface of a glass substrate tube; said substrate tube having a supply side and a discharge side, which apparatus comprises an microwave applicator and a microwave guide for guiding microwaves and forming a plasma, which applicator is movable along said substrate tube between a point of reversal located at the supply side of the substrate tube and a point of reversal located at the discharge side of the substrate tube, said apparatus being characterized in that it is provided with a gas injection device to provide the supply side of the substrate tube with glass-forming gases and plasma-reactive gas, and wherein said gas injection device comprises an additional gas line attached to the supply side of the substrate tube and a valve to control a flow of plasma-reactive gas, to provide said plasma-reactive gas in one or more pulses as a function of the axial position of the applicator along the length of the substrate tube during the PCVD deposition process.

Said gas injection device comprises a valve, preferably a fast valve, to control the flow of plasma-reactive gas. Said apparatus suitable for carrying out the method according to the present invention is further provided with a controller, preferably a microcontroller.

In the present description, a fast valve is a valve that switches between an open position and close position in 100 milliseconds (ms) or less.

One or more of the above aspects are accomplished by using the present method.

DETAILED DESCRIPTION OF THE INVENTION

Thus the invention relates to a method for carrying out a PCVD deposition process according to claim 1 comprising several steps. Step i) providing a glass substrate tube. Generally, said substrate tube has a supply side and a discharge side. Step ii) supplying one or more glass-forming gasses to the substrate tube, preferably via the supply side; preferably via a valve system/injection system. Preferably said glass-forming gases are doped or undoped. Step iii) inducing a plasma on at least a part of the substrate tube to induce deposition of one or more doped or undoped glass layers onto the interior surface of the glass substrate tube; by means of the plasma the glass-forming gasses are converted to solid state to form glass layers. Said plasma is preferably induced by a microwave applicator that moves along the substrate tube in forth-and-back movement. The present invention is characterized in at least one plasma-reactive gas in pure form is supplied to the substrate tube in one pulse as a function of the position of the plasma along the length of the substrate tube.

The present invention is described below in detail with reference to the drawings in which:

Figure 1 shows a graph of the cross-sectional area (CSA) value for the core of the solid rod in square millimeters plotted against the longitudinal position on the tube with respect to the supply side of the tube. This graph depicts a method not according to the invention, wherein no pulses with a plasma reactive gas are provided.

Figure 2 shows a graph of the CSA value in square millimeters plotted against the longitudinal position on the tube with respect to the supply side of the tube. This graph depicts a method according to the invention, wherein one pulse with a plasma reactive gas is provided.

Figure 3 shows a graph of the alpha value (no unit) plotted against the longitudinal position on the tube with respect to the supply side of the tube. This graph depicts a method not according to the invention, wherein no pulses with a plasma reactive gas are provided.

Figure 4 shows a graph of the alpha value (no unit) plotted against the longitudinal position on the tube with respect to the supply side of the tube. This graph depicts a method according to the invention, wherein one pulse with a plasma reactive gas is provided.

Figure 5 shows a graph of the alpha value (no unit) plotted against the longitudinal position on the tube with respect to the supply side of the tube. This graph depicts a method not according to the invention (dotted line), wherein multiple pulses with a plasma reactive gas is provided. The solid line shows a method not according to the invention, wherein no pulses with a reactive gas are provided.

The present inventors have found that a non-uniform distribution of the microwave energy was observed, which was caused inter alia by dispersion or scattering of the microwave power. The present inventors assume, without wishing to be bound by such a theory, that part of the microwave power moves on the boundary between the plasma and the substrate tube. A standing wave may form on the inner side of the substrate tube which standing wave can move to beyond the generated plasma. The microwaves may be scattered outside of the plasma frontline and may be reflected by conductive surfaces, for example the inner wall of the surrounding furnace, but also by semi-conductive surfaces. More in general it can be stated that microwaves are reflected at the moment a transition of materials takes place, viz. air-water, metal-plastic, air-ceramics and the like. Thus it is assumed that the resulting distribution of the microwaves relative to the applicator depends on the position of the applicator, causing so-called non-uniform microwave powers, which may result in non-uniform temperatures and even multiple plasmas. The latter occurs when the amount of leakages of microwaves is such that increased microwave concentrations are present at different positions in the substrate tube, which increased concentrations produce a plasma of their own (outside of the applicator). This is possible since the furnace encloses not only the substrate tube within the applicator but also a large part of the remainder of the substrate tube. This ensures that a large part of the substrate tube is heated to a high temperature, e.g. 900-1300 °C

Previously, in European patent application EP 1,923,360 the present inventors have presented that by making the applicator as well as the furnace reciprocally movable with respect to the longitudinal axis of the substrate tube, the non-uniform microwave distribution during the PCVD process is weakened.

However, the present inventors have recently found that an additional phenomenon occurs when the applicator approaches the discharge side of the substrate tube.

The plasma that is induced occupies a certain space that is dependent on the power of the resonator. The width of the plasma is determined by the interior space inside of the substrate tube. With increasing number of passes and thus decreasing open diameter of the substrate tube, the longitudinal length of the plasma will increase if the power of the resonator stays the same, viz. the space of the plasma will stay the same.

The inventors have found that at a certain point in the process the hollow internal space of the substrate tube will be reduced to such an extent that during the back and forth movement of the resonator, the plasma will extend outside of the furnace that is present around the substrate tube, especially when the applicator is approaching the discharge side of the substrate tube. The "tail" of the plasma in the direction of the gas flow (i.e. the "tail" in the direction of the pump) will become so large that it extends outside of the furnace. The scattering of the microwaves into the air is large. The inventors visually observed a pumping or oscillating movement of the plasma wherein the "tail" of the plasma is alternatively visible to a larger extent and to a smaller extent. In other words, it is visible that the plasma moves a bit forward and a bit back and again forward and back.

Because of the wavelength of the microwaves in air, there will be no continuous reflection but discontinuous or stepwise or oscillation reflection. This will lead to stepwise or oscillating perturbation of the plasma.

It can thus be said that the plasma has a dual movement. Primarily the plasma moves linearly with the movement of the applicator along the length of the substrate tube. Secondly, the plasma can show - generally only in a part of the substrate tube - an oscillating forwards-backwards movement due to scattering of microwave energy. This second movement is generally only visible in part of the process, i.e. near the discharge side of the substrate tube. Moreover, it might be the case that during the first several passes or strokes this second oscillating behavior of the plasma is not visible at all or not even present at all. If the internal hollow space of the substrate tube is sufficiently large in diameter, the plasma will has sufficient room. However, as the power of the generator or resonator stays the same and the diameter of the free space inside of the substrate tube will decrease with increasing number of passes, this phenomenon of oscillating plasma will occur.

The formation of glass deposition on the inside of the substrate tube only takes place at the position at which a plasma is present. The glass forming gasses may be doped or may be undoped. If the position of the frontline of front end of the plasma varies in a discontinuous way (i.e. by means of a pulse or oscillating manner) the deposition of glass will show a similar behavior (called "deposition oscillation"). In one pass there will not be a completely smooth thin deposition film formed. On the position of the substrate tube where the (cumulative) duration of plasma presence is higher, a larger or thicker layer of glass is formed. This effect is reinforcing itself, meaning that in a next pass the "thick spots" will generate more heat due to the poor heat conductivity of glass and will lead to even more glass deposition in the next layers. This increases the effect of the deposition oscillation.

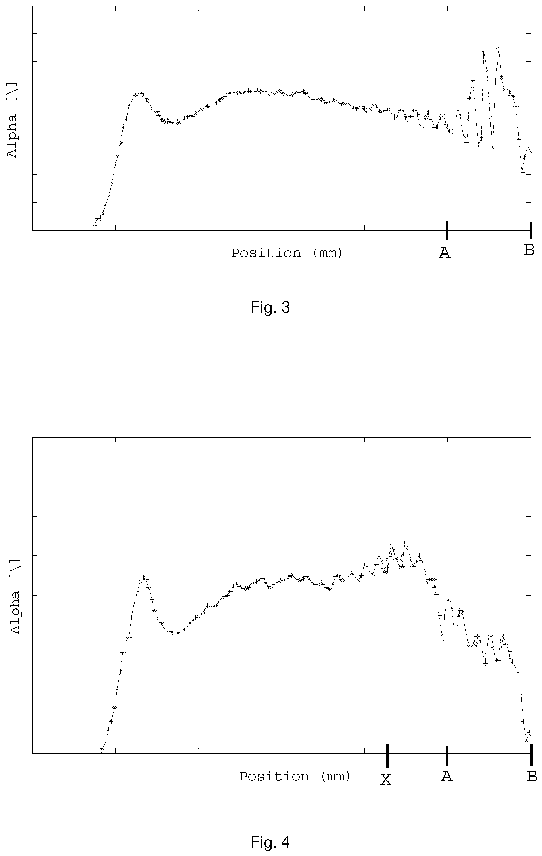

Figure 3 shows a variation in the alpha value. The alpha value is the value determining the shape of the refractive index profile. Deposition oscillation as described above will lead to variation or oscillation in the alpha value, as clearly visible from the right side of figure 3.

For optical fibers, the refractive index profile is generally qualified as a "step", "trapezoidal" or "triangular" or "alpha" profile for profiles having the respective shapes of a step, trapezoid, triangle or gradient. In step index fibers, the different modes propagate at different speeds along the fiber, which causes spreading of the light pulse which may become comparable to the spacing between pulses, and lead to an unacceptable error rate. To reduce intermodal dispersion in a multimode fiber, it has been proposed to manufacture graded-index fibers with an "alpha" core profile. Such fiber has been used for many years and its characteristics have been described in particular in the publications: "Multimode theory of graded-core fibres." by D. Gloge et al., Bell System Technical Journal 1973 pp 1563-1578, and "Comprehensive theory of dispersion in graded-index optical fibers" by G. Yabre, Journal of Lightwave Technology, February 2000, vol. 18, n° 2, pp 166-177.

A graded-index profile can be defined as the relation between the value n of the index at one point in relation to the distance r from this point to the center of the fiber:

$$n = n_1 \sqrt{1 - 2\Delta\left(\frac{r}{\alpha}\right)^{\alpha}}$$

where a > 1; (a $\rightarrow\infty$ corresponding to a step index); $n_1$, the maximum index value of the multimode core; a, the radius of the multimode core; and

$$\Delta = \frac{(n_1^2 - n_0^2)}{2n_1^2}$$

where $n_0$ is the minimum index value of the multimode core, generally corresponding to the index value of the cladding (which is most often of silica). A graded-index multimode fiber therefore has a core profile with a revolution symmetry such that, along any radial direction, the value of the index decreases continuously from the center of the fiber towards its periphery.

When a multimode light signal propagates in said graded-index core, the different modes see a different propagation medium, which has a different effect on their speed of propagation. By adjusting the value of parameter alpha, it is therefore possible to obtain a group speed that is practically equal for all the modes and hence a reduced intermodal dispersion.

In case the alpha value is one, a triangular core profile is obtained. With graded-index fibers it is desired that the alpha value is substantially constant over the longitudinal position of the substrate tube.

As mentioned above, figure 3 shows a variation in the alpha value. It shows a large oscillation between longitudinal positions A and B as shown on the graph. This is near the discharge side of the substrate tube. It is an aim of the present method to reduce these oscillations in the alpha value.

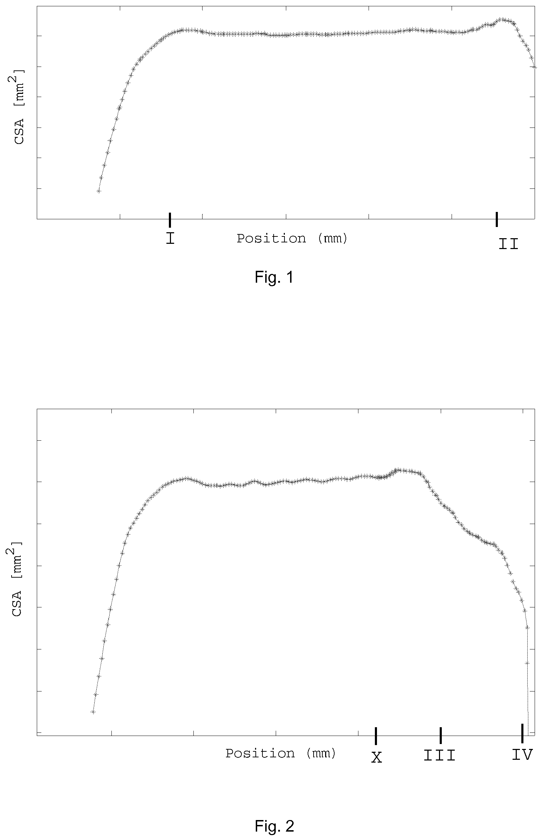

Figure 1 shows the so-called cross-sectional surface area (CSA), calculated on the basis of the thickness of the vapor-deposited layers. The aforesaid cross-sectional area (CSA) can be calculated as follows:

$$csa = \frac{\pi}{4}\left(d_u^2 - d_i^2\right)$$

wherein $d_u$ = external diameter layer x, $d_i$ = internal diameter layer x, CSA = cross-sectional surface area layer x

Figure 1 shows the CSA of the core measured after the PCVD process and the collapsing have completed. It can be seen from Figure 1 that there is a substantially constant CSA between positions I and II as shown on the graph.

Since the current commercial trend in manufacturing of optical fiber preforms tends to go towards larger (thicker preforms) more passes or strokes will be required. This leads to tubes after deposition (before collapsing) having an even smaller internal diameter. The problem of deposition oscillation (leading to alpha value oscillation), particularly in the vicinity of the discharge side of the substrate tube is becoming more and more pressing. From the observations of the oscillation phenomena it is known that the problem arises as the plasma length and the plasma front position are varying as a function of position with regards to the metal walls of the furnace. This varying plasma front causes the deposition front to change the position with regards to the resonator position and the result is a variation in thickness and the refractive index as a function of position.

The present inventors have now found a new solution to this problem. The solution is to apply certain gas (that is reactive to the plasma) as a function of the axial position of the plasma to counteract the plasma front movement, wherein a plasma reactive gas is supplied to a substrate tube in which glass-forming takes place and wherein said plasma-reactive gas interacts with said plasma to reduce the size of the plasma and thus changing the position of the front line of the plasma in order to minimize deposition oscillation This can for example be done by using the gas injection device that is already present in the PCVD apparatus to inject glass-forming gases. This gas injection device can be altered by adding an additional gas line connected via a fast valve which is connected to a (micro)controller.

The present inventors try without wishing to be bound by such a theory, to reduce the oscillating behavior of the plasma, preferably at the moment it extends outside of the furnace, by "pushing back" the plasma. This is obtained by exposing the plasma during a period of time to a gas that has an effect on the plasma. The gas is supplied in one pulse and the gas is preferably supplied into the substrate tube from the supply side thereof. This plasma-reactive gas has the effect of reducing the size of the plasma and thus changing the position of the front line of the plasma. The timing and duration of this gas pulse are determined by the inventors prior to starting the PCVD process according to the present invention. The inventors use the data obtained from a similar process using a similar substrate tube and similar reaction conditions. During such a test process data is obtained such as depicted in Figures 1 and 3. Based on these figures the longitudinal position of the "thick spots" is determined as well as the width and height of these spots. Based on these parameters the inventors determine between which longitudinal positions one pulse of plasma-reactive gas is required. Moreover, the duration of the pulse and the flow rate of the gas are determined.

This inventive method has the effect of stabilizing the front line of the plasma during a pass or stroke. In other words, the oscillation behavior of the plasma is reduced or even eliminated.

In the present invention one single pulse of plasma-reactive gas is provided, said pulse having a duration of for example between 110, or 250, and 1000 milliseconds or even longer. The timing or placement of the pulse is selected to fall in longitudinal position corresponding to the deposition oscillation.

The duration of the pulse can vary according to the amount of plasma-reactive gas needed. For example, the duration can be between 1 and 1000 milliseconds, for example between 25 and 750 milliseconds. The duration of the pulse can be determined by a skilled person together with the size of the opening (orifice) through which the gas flows, the flow speed or pressure of the gas, and the composition of the gas.

The pressure of the gas can for example be between 0.5 and 5 bar, preferably between 1 and 2 bar. The pressure of the gas can be determined by a skilled person together with the size of the opening through which the gas flows, the flow speed of the gas, the duration of the pulse and the composition of the gas.

For example, if the duration of the pulse is doubled the flow rate should be halved in order to obtain the same amount of plasma-reactive gas. If the concentration of the plasma-reactive gas is decreased due to dilution with a non-plasma-reactive gas, e.g. the duration of the pulse or the size of the gas inlet or the pressure or flow speed should be increased to maintain the same amount of plasma-reactive gas.

Plasma-reactive gases include Argon, Helium, Nitrogen and Oxygen. In an example Argon is used. In another example Helium is used. In another example Nitrogen is used. The influence of the gasses depends on the type used and the maximal flow. When for example a certain amount of Oxygen is added, the plasma will tend to shorten or decrease in size. Preferably oxygen is used as plasma-reactive gas.

The plasma-reactive gases can be used either in pure form, in combination with each other and/or in combination with non-plasma-reactive gases (viz. in diluted form). An example of a non-plasma-reactive gas is Freon. An example of a diluted form is 5% Freon ($C_2F_6$) in oxygen ($O_2$).

In an embodiment of the present invention an additional gas line is attached to the supply side of the substrate tube. By means of a valve, e.g. a so called fast valve, this gas line - for the supply of plasma-reactive gas - is coupled to the supply system of glass-forming gasses. The valve for supplying the plasma-reactive gas can be connected to an orifice having a certain opening size. The size of the opening has a direct influence on the amount of gas that is guided through the orifice.

The valve (or fast valve) can optionally be coupled to controller means, i.e. a microcontroller which measures the position of the applicator and controls the duration of the opening of the valve and in that way controlling the positions at which and the amount of gas that introduced into the substrate tube.

The invention thus offsets any changes caused by plasma length or front position variations, by injecting a burst of certain gases (e.g. $O_2$, Ar, He). The pulse or burst or injection of the plasma-reactive gases is injected as a function or the position of the resonator or application along the axial position of the substrate tube. For example by using a fast valve and microcontroller, a gas burst is injected time wise in such a way that the plasma length / front position deviations (increases) are offset (decreased) as a function of resonator position along the axial direction of the substrate tube. The increased gas flows (total gas flows and $O_2$ concentration) of the burst, e.g. with $O_2$ being the only carrier gas, are used to shorten the plasma length. In particular, the length (valve open time) and/or magnitude ($O_2$ flow rate) of the $O_2$ burst can be varied as a function of the axial position of the resonator, e.g. to offset plasma length / front position deviations (deposition oscillations) which can vary in length and/or magnitude along the tube (e.g. between the middle of the tube and the pump side of the tube). The above is also applicable for other plasma-reactive gases besides $O_2$.

The present invention does not required significant changes to the instrumental setup or apparatus that are already in use. Therefore, the solution to the problem presented in the present invention are easy and cost-effective to implement.

It is possible to determine an injection protocol in which the valve opens only in the vicinity of the reversal point at the discharge side. For example, it is possible that the injection only occurs at positions near the discharge side. For example in the last 150-400 or 150-200 millimeters of the substrate tube near the discharge side.

In an embodiment of the invention the pulse or burst of injection is provided during every pass at the same position. It is also possible to determine the position for each separate pass or stroke and to adjust the position between passes or strokes. This can be selected depending on e.g. the concentration Germanium or the internal diameter. This ensures the same environment during the complete PCVD process to minimize possible perturbations of optical properties if the conditions are changes in between passes.

It is however also possible to determine a different injection protocol in which the valve opens only during the last several passes of a PCVD process. A skilled person will, based on experimentation, be able to decide the best protocol.

Figure 2 shows a graph that is comparable to Figure 1 as described above. Figure 2 is measured on a tube prepared with the method according to the invention as disclosed in Example 1. This graph clearly shows that the plasma-reactive gases have an effect of the plasma. In Figure 2, between the longitudinal positions of III and IV the CSA value decreases. This means that there is decrease in the glass-forming yield compared to Figure 1 where no plasma-reactive gas is added due to decrease in plasma.

Figure 4 shows a graph that is comparable to Figure 3 as described above. Figure 4 is measured on a tube prepared with the method according to the present invention as disclosed in Example 1. The graph in Figure 4 clearly shows that the present invention has the desired effect. The oscillating behavior in the alpha value in the region between A and B is greatly reduced. Hence the present invention provides the desired effect and reaches one or more of the goals cited in the beginning.

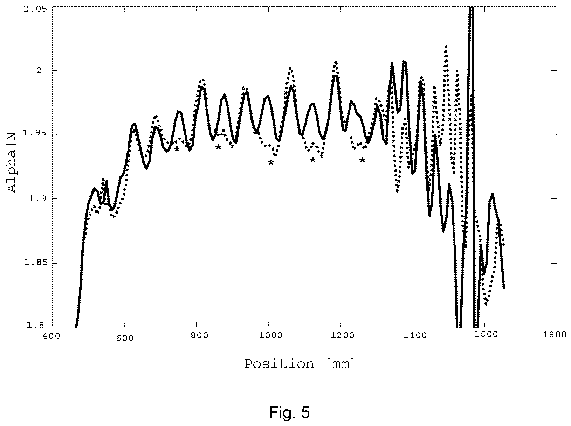

Figure 5 shows a graph that is comparable to Figure 4, wherein the measurements are conducted on a tube prepared with the method not according to the present invention as disclosed in Comparative Example 2 (dotted line) and compared to a method of the prior art (solid line).

The graph in Figure 5 shows a solid black line that represents measurement conducted on a tube according to a method as described in Comparative Example 1. It is clear that there is a large oscillation in alpha value between 660 and 1240 mm.

On the other hand the dotted line in Figure 5 shows measurements carried out according to the invention. The oscillating behavior in the alpha region is greatly reduced between 660 and 1240 mm, particularly at the positions where a pulse is applied, as indicated by the asterisks at 1240, 1140, 1020, 900 and 780 mm.

As already mentioned previously, a skilled person determines the injection protocol based on a test PCVD process during which graphs similar to Figure 1 and Figure 3 are prepared. Since the phenomenon that occurs is a physical phenomenon, it will occur exactly at the same positions each time provided the wavelength of the microwaves is not changed. This process is completely reproducible irrespective of the width of the original substrate tube used and irrespective of the number of passes used.

It is preferred to deposit layers of glass to a final internal diameter of the substrate tube of maximally 22 millimeters or even to a internal diameter of the substrate tube of maximally 20 millimeters.

The refractive index value and the alpha value of the substrate tube thus obtained after internal deposition is substantially uniform along the length thereof.

In a preferred embodiment it is preferable if the substrate tube is fixed or clamped in position in the apparatus on both ends thereof and the applicator (and optionally also the furnace) is movable along the longitudinal axis of the substrate tube. Such a construction is in particular advantageous because the existing PCVD equipment can be adapted in a simple manner. It is also possible to rotate the substrate tube during the deposition process or externally flush it with an inert gas so as to prevent deposition of furnace particles on the outer side of the substrate tube.

In order to realize an effective operation of the present invention it is preferable if the distance over which the applicator is movable between a point of reversal located at the supply side and a point of reversal located at the discharge side of the substrate tube is selected so that the furnace will surround the applicator at all times. Said moving of the furnace may take place continuously, discontinuously or in steps. In other words, the applicator will be moved in such a manner during the deposition process that the furnace, which is likewise movable, will surround the applicator at all times, which means that the applicator cannot move outside the furnace. This means that the applicator, which is movable along the length of the substrate tube, will at all times be positioned within the furnace, which is movable along the length of the substrate tube as well. The deposition of glass layers takes place along the distance over which the applicator is moved. The substrate tube has a length greater than the sum of the length of the furnace and the "stroke" of the movable furnace. The reason for this is that both ends of the substrate tube are fixed in clamps which cannot withstand the high temperature that prevails in the furnace.

The applicator is preferably cylindrically symmetrical and annular in shape, comprising a resonator space which extends cylindrically symmetrically around the cylindrical axis and which is annular in shape, which resonator space comprises a slit which extends in a full circle around the cylindrical axis, through which slit the microwave energy from the microwave guide is transported, wherein more in particular the microwave guide opens into the resonator space.

To realize an optimum transfer of the microwave energy, it is preferable if the waveguide has a longitudinal axis which extends substantially perpendicularly to the cylindrical axis, which longitudinal axis does not intersect the slit or the passage, wherein more in particular the longitudinal axis does not divide the resonator space into two equal halves.

The applicator and the furnace may move in the same direction or in opposite directions along the length of the substrate tube.

In a specific embodiment it is preferable if the furnace moves in a stepwise movement along the length of the substrate tube. Said stepwise movement may be understood to comprise movement of the furnace to a location, for example at the discharge side of the substrate tube, maintaining this position for some time and subsequently returning the furnace to the original or other location, for example at the supply side of the substrate tube. This latter position is preferably maintained for some time as well, whereupon the furnace is moved to the location at the discharge side of the substrate tube again. It is also possible to have the furnace move in steps, for example from the supply side towards the discharge side, during which movement the furnace will thus be stationary for some time at specific positions along the length of the substrate tube, after which the furnace will continue on its way and be stopped again. According to such a velocity profile the furnace is moved reciprocally along the length of the substrate tube in steps, seen in time. The aforesaid cycle may be repeated during the entire deposition process or during part of the deposition process. The present inventors have found that the cycle time of the above-described movement of the furnace preferably ranges between 1 and 600 seconds. A value of more than 600 seconds will lead to disturbances in the profile, whilst a value of less than 1 second will lead to insufficient results regarding the intended uniformity of the CSA and the refractive index profile. In addition to that, a value of less than 1 second may lead to mechanical problems. In the embodiment that uses a furnace and applicator moving along the length of the substrate tube it is preferable if the ratio between the cycle time of the furnace and the cycle time of the applicator does not equal an integer. To determine the aforesaid ratio, the quotient of the longest cycle time and the shortest cycle time must be taken.

The movement of the furnace over the substrate tube preferably equals an uneven multiple of a quarter of the wavelength of the microwaves being used. In practice suitable microwaves have a frequency of, for example, 2.45 GHz, 890 MHz or 5.8 GHz. In practice distances of 30, 90, 150 mm and the like are particularly used. The term "movement" is to be understood the distance over which the furnace is moved in the longitudinal direction of the substrate tube.

According to another embodiment of the present method, the furnace is continuously moved between the two locations at the supply side and the discharge side of the substrate tube. It is preferable in that case if the distance over which the furnace is moved is an uneven multiple of a quarter of the wavelength of the microwaves being used. It is furthermore preferable if the quotient of the longest cycle time and the shortest cycle time does not equal an integer when comparing the cycle time of the furnace to the cycle time of the applicator. For practical reasons a rate of movement of the furnace of less than 5 cm/sec, in particular less than 1 cm/sec is used.

Although a moving furnace has been described so far, it is also possible in a specific embodiment to provide the furnace internally with parts or elements that move along the length of the substrate tube. In such an embodiment the furnace as such takes up a stationary position, whilst the parts or elements, preferably made of a metal, which are arranged concentrically around the substrate tube, are being moved in order to thus prevent a disturbance of the microwave energy along the length of the substrate tube, seen in time, during the deposition process.

According to another embodiment of the present invention, the substrate tube, including the connections as known to the skilled person, is movable with respect to the stationary furnace and applicator.

The term "movable along the longitudinal axis" as used herein is to be understood to be a movement along the length of the substrate tube, which movement can take place not only parallel to the substrate tube, seen in the longitudinal direction thereof, but also at a certain angle, for example from the upper side to the bottom side or from the front side to the rear side.

After the glass layers have been deposited onto the interior of the glass substrate tube, the glass substrate tube is subsequently contracted by heating into a solid rod ("collapsing"). In an embodiment, the solid rod may furthermore be externally provided with an additional amount of glass, for example by means of an external vapor deposition process or by using one or more preformed glass tubes, thus obtaining a composite preform. From the preform thus produced, one end of which is heated, optical fibers are obtained by drawing on a drawing tower to produce optical fibers.

The present invention will now be explained on the basis of a number of examples, in which connection it should be noted, however, that the present invention is by no means limited to such special examples.

EXAMPLES Comparative Example 1

A PCVD process was carried out in a PCVD apparatus comprising a stationary substrate tube, a furnace moving reciprocally over said substrate tube and an applicator moving reciprocally over said substrate tube, during which process glass-forming precursors were supplied to the interior of the substrate tube. The effective length of the furnace (viz. the internal length without the thickness of the furnace walls) is approximately 1.7 meter. The length of a substrate tube is approximately 2 meters. The length of an applicator is approximately 0.2 meter. The applicator moves with a speed of approximately 330 millimeters per second. The external diameter of the substrate tube is 39 millimeters and the internal diameter of the substrate tube is 34 millimeter. Under the conditions that prevailed in the interior of the substrate tube, concentric glass layers were deposited, using a usual applicator velocity of 30 centimeters per second.

After the deposition process had been terminated, the substrate tube thus obtained was subjected to a contraction process so as to obtain a solid rod (primary preform). Figure 1 shows the Cross Sectional Surface Area (CSA) and Figure 3 shows the alpha value of the core of the rod thus obtained as a function of the axial position. Figures 1 and 3 show that there is non-uniformity over the axial position of the glass rod. Such non-uniformity has an adverse effect on a number of quality parameters of the optical fiber obtained there from, such as the attenuation and the uniformity of the mode field width and bandwidth.

Example 1

The same PCVD apparatus as in Comparative Example 1 was used, with this difference that one long pulse of oxygen was given, starting at the axial position of 1240 millimeters (referenced by X in Figures 2 and 4), having a duration of 750 milliseconds and wherein the size of the opening through which the gas flows has an orifice no. 28 (Kv parameter value of 0.011 $m^3n$/hour) and having a pressure of 1.5 bar. The substrate tube thus obtained was formed into a solid rod in the same manner as in comparative example 1

Comparative Example 2

The same PCVD apparatus as in Example 1 was used, with the difference that 5 pulses of 5 % Freon (95 % oxygen) was given, starting at the axial position of 1240 millimeters and repeated at 1140, 1020, 900, 780, and 660 millimeters, (referenced by an asterisk in Figure 5), having a duration of 50 milliseconds and wherein the size of the opening through which the gas flows has an orifice no. 28 (0.028 inch) (Kv parameter value of 0.011 $m^3n$/hour) and having a pressure of 1.8 bar. The substrate tube thus obtained was formed into a solid rod in the same manner as in comparative example 1.

The solid rod thus obtained was subjected to the same measurements as the solid rod obtained in Comparative Example 1.

Figure 2 shows the Cross Sectional Surface Area (CSA) and Figure 4 shows the alpha value of the core of the rod thus obtained as a function of the axial position. Figures 2 and 4 clearly show the effect of the present invention. Figure 4 shows that there is uniformity over the axial position of the glass rod for the alpha value. Such uniformity eliminates any adverse effect that where present in Comparative Example 1.

Therefore, one or more aims of the present invention mentioned above have been reached. More embodiments of the present invention as cited in the appended claims.

**Claims**

1. A method for carrying out a PCVD deposition process, said method comprising the steps of:

   i) providing a glass substrate tube;
   ii) supplying one or more glass-forming gasses to the substrate tube of step i);
   iii) inducing a plasma by means of microwave radiation on at least a part of the substrate tube of step ii) to induce deposition of one or more glass layers onto the interior surface of the substrate tube;

   wherein at least one plasma-reactive gas is supplied to the substrate tube during step iii) in one or more pulses as a function of the axial position of the plasma along the length of the substrate tube, **characterized in that** one single pulse is supplied of plasma-reactive gas and wherein the length and position of said pulse is selected to fall in a longitudinal position corresponding to a deposition oscillation, said deposition oscillation being a variation in the thickness or composition of the deposited glass over the length of the substrate tube, wherein the plasma-reactive gas is selected from the group consisting of Argon, Helium, Oxygen, Nitrogen and one or more combinations thereof.

2. A method according to claim 1, wherein said plasma-reactive gas is Oxygen.

3. A method according to claim 1 or 2, wherein said pulse is provided during every pass or wherein said pulse is provided during the last several passes of said PCVD deposition process.

4. The method according to any of the preceding claims, wherein the pulse has a duration of between 250 and 1000 milliseconds.

5. The method according to claim 4, wherein the pulse has a duration of between 500 and 750 milliseconds.

6. The method according to any one of the preceding claims, wherein the pressure of the plasma-reactive gas is between 0.5 and 5 bar.

7. The method according to claim 6, wherein the pressure of the plasma-reactive gas is between 1 and 2 bar.

8. The method according to any one of the preceding claims, wherein the length and position of the pulse are selected such that the effect is present on the last part of the forward movement of a pass.

9. The method according to any one of the preceding claims, wherein the length and position of the pulse are selected such that the effect is present on the first part of the backward movement of a pass.

10. The method according to any one of the preceding claims, wherein the plasma-reactive gas is a non glass-forming precursor capable of being ionized in a plasma.

**Patentansprüche**

1. Verfahren zum Durchführen eines plasmaunterstützten chemischen Gasphasenabscheidungsprozesses (PCVD-Prozesses), wobei das Verfahren die folgenden Schritte umfasst:

   i) Bereitstellen eines Glasträgerrohrs;
   ii) Zuführen von einem oder mehreren glasbildenden Gas(en) zu dem Trägerrohr aus Schritt i); und
   iii) Induzieren eines Plasmas mittels Mikrowellenstrahlung an mindestens einem Teil des Trägerrohrs aus Schritt ii) zum Induzieren einer Abscheidung von einer oder mehreren Glasschichten auf der Innenfläche des Trägerrohrs;

   wobei dem Trägerrohr während des Schritts iii) in einem oder mehreren Impulsen in Abhängigkeit von der Axialposition des Plasmas entlang der Länge des Trägerrohrs mindestens ein Plasma-Reaktivgas zugeführt wird, **dadurch gekennzeichnet, dass** ein Einzelimpuls von Plasma-Reaktivgas zugeführt wird, und wobei die Länge und Position des Impulses so ausgewählt ist, dass sie in eine Längsposition hineinfällt, die einer Abscheidungsoszillation entspricht, wobei die Abscheidungsoszillation eine Variation in der Dicke oder Zusammensetzung des abgeschiedenen Glases über die Länge des Trägerrohrs ist, wobei das Plasma-Reaktivgas aus der Gruppe bestehend aus Argon, Helium, Sauerstoff, Stickstoff und einer oder mehreren Kombinationen davon ausgewählt wird.

2. Verfahren nach Anspruch 1, wobei das Plasma-Reaktivgas Sauerstoff ist.

3. Verfahren nach Anspruch 1 oder 2, wobei der Impuls während jedes Durchlaufs bereitgestellt wird oder wobei der Impuls während der mehreren letzten Durchläufe des PCVD-Prozesses bereitgestellt wird.

4. Verfahren nach einem der vorangehenden Ansprüche, wobei der Impuls eine Dauer von zwischen 250 und 1000 Millisekunden hat.

5. Verfahren nach Anspruch 4, wobei der Impuls eine Dauer von zwischen 500 und 750 Millisekunden hat.

6. Verfahren nach einem der vorangehenden Ansprüche, wobei der Druck des Plasma-Reaktivgases zwischen 0,5 und 5 bar liegt.

7. Verfahren nach Anspruch 6, wobei der Druck des Plasma-Reaktivgases zwischen 1 und 2 bar liegt.

8. Verfahren nach einem der vorangehenden Ansprüche, wobei die Länge und Position des Impulses derart ausgewählt sind, dass die Wirkung in dem letzten Teil der Vorwärtsbewegung eines Durchlaufs vorhanden ist.

9. Verfahren nach einem der vorangehenden Ansprüche, wobei die Länge und Position des Impulses derart ausgewählt sind, dass die Wirkung in dem ersten Teil der Rückwärtsbewegung eines Durchlaufs vorhanden ist.

10. Verfahren nach einem der vorangehenden Ansprüche, wobei das Plasma-Reaktivgas eine nicht-glasbildende Vorstufe ist, die in einem Plasma ionisierungsfähig ist.

**Revendications**

1. Procédé de réalisation d'un procédé de dépôt chimique en phase vapeur assisté par plasma (PCVD), ledit procédé comprenant les étapes consistant :

   i) à fournir un tube substrat en verre ;
   ii) à alimenter le tube substrat de l'étape i) en un ou plusieurs gaz vitrifiable(s) ;
   iii) à induire un plasma au moyen d'un rayonnement micro-ondes sur au moins une partie du tube substrat de l'étape ii) pour induire le dépôt d'une ou de plusieurs couche(s) de verre sur la surface intérieure du tube substrat ;

   dans lequel au moins un gaz réactif au plasma est fourni au tube substrat pendant l'étape iii) en une ou plusieurs impulsion(s) en fonction de la position axiale du plasma sur toute la longueur du tube substrat, **caractérisé en ce qu'**une seule impulsion du gaz réactif au plasma est fournie et dans lequel la longueur et la position de ladite impulsion sont choisies de manière à se situer dans une position longitudinale correspondant à une oscillation de dépôt, ladite oscillation de dépôt étant une variation de l'épaisseur ou de la composition du verre déposé sur la longueur du tube substrat, dans lequel le gaz réactif au plasma est choisi dans le groupe constitué par l'argon, l'hélium, l'oxygène, l'azote et une ou plusieurs combinaison(s) de ceux-ci.

2. Procédé selon la revendication 1, dans lequel ledit gaz réactif au plasma est de l'oxygène.

3. Procédé selon la revendication 1 ou 2, dans lequel ladite impulsion est fournie lors de chaque passe ou dans lequel ladite impulsion est fournie lors des au moins dernières passes dudit procédé de dépôt PCVD.

4. Procédé selon l'une des revendications précédentes, dans lequel l'impulsion a une durée comprise entre 250 et 1000 millisecondes.

5. Procédé selon la revendication 4, dans lequel l'impulsion a une durée comprise entre 500 et 750 millisecondes.

6. Procédé selon l'une quelconque des revendications précédentes, dans lequel la pression du gaz réactif au plasma est comprise entre 0,5 et 5 bars.

7. Procédé selon la revendication 6, dans lequel la pression du gaz réactif au plasma est comprise entre 1 et 2 bars.

8. Procédé selon l'une quelconque des revendications précédentes, dans lequel la longueur et la position de l'impulsion sont choisies de sorte que l'effet soit présent sur la dernière partie du mouvement vers l'avant d'une passe.

9. Procédé selon l'une quelconque des revendications précédentes, dans lequel la longueur et la position de l'impulsion sont choisies de sorte que l'effet soit présent sur la première partie du mouvement vers l'arrière d'une passe.

10. Procédé selon l'une quelconque des revendications précédentes, dans lequel le gaz réactif au plasma est un précurseur non vitrifiable capable d'être ionisé dans un plasma.

Fig. 1

Fig. 2

Fig. 3

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4314833 A
- WO 9935304 A
- EP 1550640 A
- US 20050172902 A
- US 4741747 A
- US 4857091 A
- GB 2068359 A
- EP 2199263 A
- US 20100154479 A
- US 6901775 B
- EP 1923360 A
- US 20090022906 A
- US 20110247369 A

**Non-patent literature cited in the description**

- **D. GLOGE et al.** Multimode theory of graded-core fibres. *Bell System Technical Journal,* 1973, 1563-1578
- **G. YABRE.** Comprehensive theory of dispersion in graded-index optical fibers. *Journal of Lightwave Technology,* February 2000, vol. 18 (2), 166-177